# EUROPEAN PATENT APPLICATION

(11) **EP 2 879 190 A1**
(43) Date of publication of application: **03.06.2015**
(21) Application number: 13195011.5
(22) Date of filing: 29.11.2013
(51) Int. Cl.: H01L 31/0296, H01L 31/068, H01L 31/18, H01L 31/103

(54) **A method for formation of a graded band gap p-n homojunction in cadmium telluride**

(71) Applicant: Rigas Tehniska Universitate, 1658 Riga (LV)
(72) Inventor: Medvids, Arturs, LV-1002 R ga (LV); Onufrijevs, Pavels, LV-1083 R ga (LV)
(74) Representative: Vitina, Maruta

(57) **Abstract**

The invention relates to technical physics and can be used in the production of light-absorbing and light-emitting semiconductor devices. The technical problem to be solved by the present invention is to simplify a method for formation of a shallow graded band gap p-n homojunction in cadmium telluride. In a method for formation of a graded band gap p-n homojunction in cadmium telluride, according to the present invention, the surface of the p-type electrical conductivity cadmium telluride single crystal is coated with a layer of silicon dioxide with thickness no more than 100 nm and then the surface of the p-type electrical conductivity cadmium telluride single crystal is irradiated by laser radiation with an absorption coefficient in cadmium telluride no less than 5.9·10⁵ cm⁻¹, the laser radiation doses being in the range from 1 to 15 mJ/cm², and the pulse duration being in the interval from 1 to 10 ns, to form the graded band gap p-n homojunction with the thickness of the n-type layer equal to or less than 17 nm on the surface layer of the cadmium telluride single crystal.

## Description

The invention relates to technical physics and can be used in the production of light-absorbing and light-emitting semiconductor devices.

A method for forming a p-n junction on p-type electrical conductivity mercury cadmium telluride by laser process is known [Patent CN101315957], which includes irradiation of p-type electrical conductivity mercury cadmium telluride by titanium sapphire laser with the pulse duration of 120 fs, wavelength 800 nm and maximum output energy 600 µJ, thus forming a porous area melted and corroded on the material by the laser; the diameter of the pore is within a range from several micrometers to ten micrometers or so; an inversion area, namely, an n-type electrical conductivity area is formed in the several micrometer area around the pore; the inversion area and the p-type area at the periphery of the pore form a p-n junction area.

However, the main disadvantages of the known method are that the formed p-n junction is not shallow and is not suitable for miniaturized semiconductor devices. In addition, it is impossible to form a graded band gap structure by this method.

A method for producing a CdTe based multi-layer graded band gap photovoltaic device is known, [Patent Application Publication GB2384621A] which comprises the annealing of n-type doped CdTe/CdS causing the intermixing of CdS and CdTe and forming ternary and/or quaternary compounds creating a graded band gap structure at the n-n heterojunction. However, the known method is multistaged, complicated and needs the additional doping of CdTe and CdS but the formed graded p-n junction is not shallow. Moreover, the used different semiconductors have lattice mismatch, which leads to the generation of additional defects at the interface of the semiconductors induced by mechanical stresses.

The technical problem to be solved by the present invention is to simplify a method for formation of a shallow graded band gap p-n homojunction in cadmium telluride. In a method for formation of a graded band gap p-n homojunction in cadmium telluride comprising the step of formation of a p-n junction in a p-type electrical conductivity cadmium telluride single crystal by irradiating the surface with a pulsed laser, according to the present invention, the surface of the p-type electrical conductivity cadmium telluride single crystal is coated with a layer of silicon dioxide with thickness not more than 100 nm and then the surface of the p-type conductivity cadmium telluride single crystal is irradiated by laser radiation with an absorption coefficient in cadmium telluride not less than 5.9•10⁵ cm⁻¹, the laser radiation doses being in the range from 1 to 15 mJ/cm², and the duration of the pulses being in the interval from 1 to 10 ns, to form the graded band gap p-n homojunction with the thickness of the n-type layer equal to or less than 17 nm on the surface layer of the cadmium telluride single crystal.

The layer of silicon dioxide with thickness no more than 100 nm prevents the evaporation of cadmium atoms during the irradiation of the surface of the p-type electrical conductivity cadmium telluride single crystal.

Laser parameters were selected experimentally to ensure the formation of the p-n homojunction with the n-type conductivity layer thickness equal to or less than 17 nm (the De Broglie wavelength of electron for cadmium telluride). For irradiation of the p-type electrical conductivity cadmium telluride single crystal surface only the laser radiation with an absorption coefficient not less than 5.9•10⁵ cm⁻¹ can be used to provide the laser radiation penetration depth not exceeding 17 nm. Such lasers are, for example, Nd: YAG, XeF, Ruby, Ar²⁺, N₂, Ne⁺, He-Cd, XeCl, KrF, HeAg⁺, KrCl, ArF, F₂ lasers. If the laser radiation dose is greater than 15 mJ/cm², cadmium telluride starts to melt and destroy the p-n junction. If the laser radiation dose is less than 1 mJ/cm², the p-n junction does not form. Once the n-type conductivity layer thickness is equal to or less than 17 nm, the quantum confinement effect takes place in this layer and the shallow p-n junction is formed. As a result, the cadmium telluride band gap width increases with the formation of the graded band gap p-n homojunction between the p-type electrical conductivity cadmium telluride single crystal and the irradiated n-type electrical conductivity layer. In the formed shallow graded band gap p-n homojunction there is a strong electrical field due to the huge gradient of the band gap, which prevents the recombination of electron-hole pairs at the irradiated surface of cadmium telluride. Consequently, the formed graded band gap p-n homojunction is shallow, it is suitable for the miniaturized semiconductor devices and effectively absorbs and emits light in a broad spectral range, including visible light. Its formation method is technologically simple.

The invention is explained on the drawings, showing:
Fig.1 - photoluminescence spectrum of the graded band gap p-n homojunction structure formed in the cadmium telluride single crystal;
Fig.2 - the dependence of the band gap width of the graded band gap p-n homojunction formed in the cadmium telluride single crystal on the distance to the surface of the cadmium telluride single crystal (depth).

The proposed method for formation of the graded band gap p-n homojunction in cadmium telluride is performed as follows.

The graded band gap p-n homojunction is formed in the p-type conductivity cadmium telluride single crystal with resistivity 10⁹ Ω•cm, surface roughness <1.6 nm. The surface of the p-type electrical conductivity cadmium telluride single crystal is coated with a layer of silicon dioxide with thickness 100 nm. The single crystal surface coated with silicon dioxide in the presence of air (at t° = 20°C and atmospheric pressure) is irradiated by a pulse Nd:YAG laser radiation with wavelength 266 nm (for such a laser radiation the absorption coefficient in cadmium telluride is 1.2•10⁶ cm⁻¹), laser radiation dose 10 mJ/cm², pulse duration 3 ns and pulse repetition rate 10 Hz. The laser beam diameter is 5 mm, and the sample is irradiated by point-to-point method with a laser beam perpendicular to the surface by 10 laser pulses.

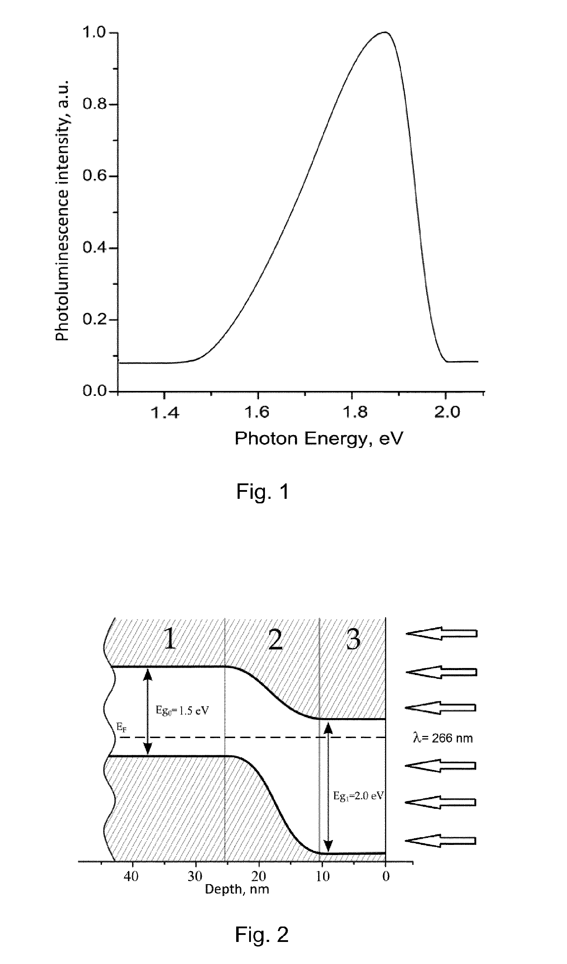

Fig. 1 shows the photoluminescence spectrum of the graded band gap p-n homojunction structure formed in the cadmium telluride single crystal, excited by an argon laser with the wavelength of 514.5 nm. The shape of the spectrum shown on Fig. 1 is asymmetric and monotonely increasing till the peak of photoluminescence spectrum at 1.85 eV. Such shape of the photoluminescence spectrum is typical of a graded band gap structure. The graded band gap p-n homojunction formed in the cadmium telluride single crystal effectively absorbs and emits light in a wide spectral range (from 1.5 and 2.0 eV), including visible light. In this graded band gap structure, irradiating it by photons with energy till 2.0 eV, no hot electrons, which negatively affect light-absorption and light-emission in semiconductor devices, are formed. In addition, due to the expansion of the band gap, the voltage generated by light-absorption semiconductor devices such as solar cells, is increased. Fig. 2 shows the schematic drawing of the dependence of the band gap width of the graded band gap p-n homojunction formed in the cadmium telluride single crystal on the distance to the surface of the cadmium telluride single crystal. The left hand side of the drawing shows the part (1) of the non-irradiated p-type conductivity cadmium telluride single crystal with the band gap width 1.5 eV. The right hand side of the drawing shows the part (3) of the n-type electrical conductivity layer, which is formed in the cadmium telluride single crystal by Nd:YAG laser irradiation, with the band gap width 2.0 eV and thickness equal to or less than 17 nm and in which the quantum confinement effect takes place. Between the part (1) of the non-irradiated p-type electrical conductivity cadmium telluride single crystal and the part (3) of the formed n-type electrical conductivity layer there is the depletion region (2) of the p-n junction with the variable width of the band gap - the graded band gap.

## Claims

1. A method for formation of a graded band gap p-n homojunction in cadmium telluride
comprising the step of formation of a p-n junction in a p-type electrical conductivity cadmium telluride single crystal by irradiating the surface with a pulsed laser,
**characterized in that**
the surface of the p-type conductivity cadmium telluride single crystal is coated with a layer of silicon dioxide with thickness not more than 100 nm and then the surface of the p-type electrical conductivity cadmium telluride single crystal is irradiated by laser radiation with the absorption coefficient in cadmium telluride not less than 5.9•10⁵ cm⁻¹, the laser radiation doses being in the range from 1 and to 15 mJ/cm², and the duration of the pulses being in the interval from 1 to 10 ns, to form the graded band gap p-n homojunction with the thickness of the n-type electrical conductivity layer equal to or less than 17 nm on the surface layer of the cadmium telluride single crystal.
